(19) Europäisches Patentamt
European Patent Office
Office européen des brevets

(11) Publication number: **0 456 346 B1**

# (12) EUROPEAN PATENT SPECIFICATION

(45) Date of publication of patent specification: **12.10.94**

(51) Int. Cl.[5]: **C09D 183/04**, C08K 5/00

(21) Application number: **91302468.3**

(22) Date of filing: **21.03.91**

## (54) Silicone organic conformal coatings.

(30) Priority: **10.04.90 US 507072**

(43) Date of publication of application:
**13.11.91 Bulletin 91/46**

(45) Publication of the grant of the patent:
**12.10.94 Bulletin 94/41**

(84) Designated Contracting States:
**DE FR GB IT**

(56) References cited:
**EP-A- 0 141 380**
**EP-A- 0 223 600**
**FR-B- 1 508 750**
**EP-A- 0 149 741**
**DE-B- 3 805 886**
**US-A- 4 511 209**

(73) Proprietor: **DOW CORNING CORPORATION**
**3901 S. Saginaw Road**
**Midland Michigan 48686-0994 (US)**

(72) Inventor: **Dennis, William Erwin**
**6205 Siebert Street**
**Midland, Michigan (US)**
Inventor: **Laubach, Carol Anne**
**2504 Kirk Point Drive**
**Midland, Michigan (US)**
Inventor: **Vanwert, Bernard**
**2159 Old Pine Trail**
**Midland, Michigan (US)**

(74) Representative: **Kyle, Diana et al**
**Elkington and Fife**
**Prospect House**
**8 Pembroke Road**
**Sevenoaks, Kent TN13 1XR (GB)**



Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to ultraviolet radiation curable compositions and more specifically to compositions which contain aliphatic unsaturated functional polysiloxane, mercapto functional compounds and acrylate compounds and are useful as conformal coatings.

Rapid radiation curable silicone compositions can be prepared from vinyl functional silicone intermediates and mercapto functional silicone intermediates. Such compositions are described in U.S. Patent No. 4,780,486, (Lee et al). The resultant cured films derived from these compositions exhibited relatively low toughness, modulus, solvent resistance and adhesion. A need exists for rapid, radiation curable silicone compositions which cure to films which exhibit improved toughness and higher modulus, solvent resistance and adhesion. The compositions described by Lee et al contain alkenyl functional, linear triorganosiloxy endblocked polydiorganosiloxane, a mercapto functional cross linker, a photosensitizer, an amine storage stabilizer and a reinforcing agent. Lee et al describe compositions which are useful as primary coatings for optical fibers with a high refractive index as containing dimethylvinylsiloxy endblocked polydiorganosiloxane having siloxane units selected from dimethylsiloxane units, methylphenylsiloxane units and diphenylsiloxane units where at least 30 percent of the organic radicals are phenyl, a mercapto organic compound selected from at least one of

$CH_3C(CH_2OOCCH_2SH)_3$,
$\{(HSCH_2CH_2COOCH_2)_3CCH_2\}_2O$,
$C(CH_2OOCCH_2CH_2SH)_4$,
$C(CH_2OOCCH_2SH)_4$,
$CH_3C(CH_2OOCCH_2CH_2SH)_3$,
$CH_3CH_2C(CCH_2OOCCH_2CH_2SH)_3$,
$CH_3CH_2C(CH_2OOCCH_2SH)_3$,

photoinitiator and viscosity stabilizers. Such compositions are useful as primary coatings for optical fibers. Lutz et al in EP-A-437 247 teach an ultraviolet radiation curable composition of a silicone resin containing phenyl and vinyl bearing siloxane units and having a degree of substitution of from 1.2 to 1.8, an organic mercaptan, a photoinitiator and a free radical inhibitor. These compositions are useful for coating paper, plastic and glass. These compositions can be varied in crosslinked density, flexibility of the cured products and the modulus of the cured products by controlling the amount of aliphatically unsaturated radicals in the silicone resin and the average degree of substitution of the silicon atoms by silicon-bonded carbon groups. The compositions cure rapidly to films with slick, tough surfaces and exhibit good adhesion to many substrates when exposed to ultraviolet radiation. In situations where shadow cure is desirable, an organic peroxide can be added to the composition. These compositions, however, suffer from low corrosion resistance to copper, poor to moderate adhesion to printed circuit board substrates and insufficient thermal resistance in many applications in which conformal coating are expected to retain there original properties at high temperatures.

An object of the present invention is to improve the composition described by Lutz et al by improving the corrosion resistance, the adhesion and the thermal resistance. The presence of the acrylate compounds in the compositions as described herein accomplish this objective.

This invention relates to a composition consisting essentially of a silicone resin having a general average unit formula

$$R_aSiO_{(4-a)/2}$$

in which each R in each unit is independently a monovalent organic radical where at least 10 mole percent of the total R are phenyl radicals and at least two R per molecule are aliphatic unsaturated radicals which react with mercapto functionality and $\underline{a}$ has an average value of from 1.2 to 1.8;

an organic mercaptan composed of carbon, hydrogen, sulfur and oxygen in which there is at least two mercapto groups per molecule;

an acrylate monomer having at least one acrylate group per molecule in an amount of at least one weight percent based on the total weight of the composition;

an effective amount of photoinitiator to cause the composition to cure upon exposure to ultraviolet radiation; and

an effective amount of a free radical inhibitor to delay gelation during storage.

The composition has more than two aliphatic unsaturated radicals per molecule in the silicone resin when the organic mercaptan has two mercapto groups per molecule or more than two mercapto groups per molecule in the organic mercaptan when the silicone resin has an average of two aliphatic unsaturated

radicals per molecule or both more than two aliphatic unsaturated radicals per molecule in the silicone resin and more than two mercapto groups per molecule in the organic mercaptan and amount of silicone resin and organic mercaptan being such that there is from 0.5 to 1.5 aliphatic unsaturated radicals in the silicone resin for each mercapto group in the organic mercaptan.

The silicone resins of the present invention contain aliphatic unsaturated radicals which react with mercapto functionality. These silicone resins have an average of 1.2 to 1.8 organic radical bonded per silicon atom and at least 10 mole percent of the organic radicals are phenyl. The silicone resins have per molecule at least two aliphatic unsaturated radicals which react with mercapto functionality. The silicone resin has a general average unit formula

$R_aSiO_{(4-a)/2}$

in which a has an average value of from 1.2 to 1.8 and R is a monovalent organic radical where at least 10 mole percent of the R are phenyl radicals and at least two R per molecule are aliphatic unsaturated radicals which react with mercapto functionality. The general average unit formula is the summation of individual siloxane units which are $SiO_2$ units, $RSiO_{3/2}$ units, $R_2SiO$ units, $R_3SiO_{1/2}$ units and each R in each siloxane unit is independently selected from the group as defined herein. Each siloxane unit does not need to be present in each silicone resin, but the siloxane units which are present need to provide an average value for a of from 1.2 to 1.8. R can be independently selected from an alkyl, alkenyl, halogenated alkyl or aryl. The alkyl radicals can be illustrated by methyl, ethyl, propyl, isopropyl, butyl, hexyl and octyl. The alkenyl radicals can be illustrated by vinyl, allyl, cyclohexenyl, 1,2-butenyl and 1,2-hexenyl. The halogenated alkyl radicals can be illustrated by 3,3,3-trifluoropropyl and other chlorinated, fluorinated and brominated alkyl radicals wherein hydrogen atoms of the alkyl radicals are replace with a halogen atom. The preferred alkenyl radicals are vinyl and hexenyl. Other preferred radicals are methyl, propyl, 3,3,3-trifluoropropyl and phenyl. Preferred silicone resins are those which are made up of at least two siloxane units selected from the group consisting of monophenylsilsesquioxane units, monomethylsilsesquioxane units, dimethylsiloxane units, diphenylsiloxane units, methylvinylsiloxane units, dimethylvinylsiloxy units and trimethylsiloxy units. The preferred silicone resins contain from 20 to 80 mole percent monophenylsilsesquioxane units where the remaining siloxane units can be those listed above. A more preferred class of silicone resins are those made up of from 20 to 40 mole percent monophenylsilsesquioxane units, 10 to 20 mole percent monomethylsilsesquioxane units, 20 to 35 mole percent dimethylsiloxane units and 10 to 30 mole percent methylvinylsiloxane units. The silicone resins can be one resin or a blend of two or more resins. The silicone resins can contain residual silicon-bonded groups which result from their preparation, such as hydroxyl groups (Si-OH) and alkoxy groups (Si-OR).

The silicone resins used in the present invention can be made by known methods. For example, cohydrolysis of hydrolyzable silanes can be used to make these silicone resins. The hydrolyzable silanes include the chlorosilanes, alkoxysilanes, ketoximosilanes and acetoxysilanes which correspond to the various siloxane units of the above silicone resin formula. To illustrate silanes which might be used to make a silicone resin, one could cohydrolyze phenyltrichlorosilane, methyltrichlorosilane, trimethylchlorosilane and methylvinyldichlorosilane. The combination of silanes are chosen to provide from 1.2 to 1.8 silicon-bonded carbon groups per silicon atom, preferably from 1.4 to 1.65 silicon-bonded carbon groups per silicon atom. The combination of silanes are also chosen to provide a silicone resin having at least 10 percent phenyl groups based on the total number of silicon-bonded carbon groups in the silicone resin. Also the combination of silanes is such that there is at least two R per molecule containing aliphatically unsaturated radicals which react with the mercapto functionality.

The crosslinked density, flexibility of cured products and the modulus of cured products are controlled by selecting the amount of aliphatically unsaturated radicals in the silicone resin and the average degree of substitution of the silicon atoms by silicon-bonded carbon groups. For example, increasing the average number of aliphatically unsaturated radicals per molecule increases the modulus and decreases the flexibility with other composition parameters remaining constant. Increasing the average degree of substitution of the silicon atom increases the flexibility and decreases the modulus with the other composition parameters remaining constant. These are general guidelines and the proportional increases and decreases in the modulus and flexibility can be varied with the kinds of other R groups, the amount of phenyl, the kind of aliphatically unsaturated radicals and the kinds and amounts of each of the siloxane units present in the silicone resin.

The organic mercaptan contains an average of at least two mercapto functional groups per molecule. In the compositions of the present invention, the number of aliphatically unsaturated groups per molecule in the silicone resin is more than two, if the number of mercapto functional groups in the organic mercaptan is

two or if the number of aliphatically unsaturated groups per molecule in the silicone resin is two, then the average number of mercapto functional groups per molecule in the organic mercaptan must be more than two. The compositions of the present invention can contain silicone resin having per molecule more than two aliphatically unsaturated groups per molecule and organic mercaptan having per molecule more than two mercapto functional groups. The organic mercaptans can be illustrated by the following: trimethylolpropane trithioglycolate, trimethylolpropane tri-(3-mercaptopropionate), trimethylolethane trithioglycolate, polyethylene glycol dimercaptoacetates, glycol dimercaptoacetate and dipentaerythritol hexa(3-mercaptopropionate). The preferred organic mercaptan is trimethylolpropane tri(3-mercaptopropionate). Mixtures of two or more organic mercaptans can be used.

The compositions of this invention contain, as an ingredient to improve the corrosion resistance, improve the adhesion to printed circuit board substrates and improve the thermal resistance, an acrylate monomer. These acrylate monomers are illustrated by trimethylolpropane trimethylacrylate, pentaerythritol tetraacrylate, ethoxylated trimethylolpropane triacrylate, pentaerythritol acrylate (contains three acrylate groups), di(trimethylmethylolpropane tetraacrylate), trimethylolpropane triacrylate, di(pentaerythritol monohydroxy pentaacrylate), hydroxylethyl acrylate, hydroxylpropyl acrylate, 4-hydroxy-n-butyl acrylate, isobornyl acrylate, proprietary acrylates such as functionalized acrylates known as Sartomer 9008 (a triacrylate), Sartomer 9012 (an aliphatic triacrylate) and Sartomer 9013 (an aliphatic monoacrylate). These are sold by ARCO Chemical Company of Pennsylvania. The acrylates are used in amounts of one weight percent or more based on the total weight of the composition.

Ultraviolet radiation capable of causing free radicals to form in the composition can be used to cure the composition of this invention. The ultraviolet radiation used to generate the free radical crosslinking reaction to effect polymerization of the composition and cure requires a photosensitization system. Examples of the photosensitization systems are known in the art, some specific photoinitiators include diethoxyacetophenone, benzophenone, dimethoxyphenylacetophenone, benzoin, 2-hydroxy-2-methyl-1-phenylpropan-1-one, with optional sensitizers such as N-methyldiethanolamine, diisopropylaminoethanol and amyldimethylaminobenzoate.

The compositions of the present invention can be prepared by mixing the ingredients at room temperature with conventional mixing equipment. In some cases the blending of the ingredients can be accomplished by some heating. Heating these ingredients can create degradation if the temperatures become too high or the duration of the heating is for prolonged periods of time. The ingredients used to make the compositions of the present invention should be blended to make compatible mixtures. This compatibility is desirable to ensure that the cured products will form solid coherent coatings, films, sheets and encapsulants with consistent properties throughout. Incompatibility can cause weak spots, fisheyes and poor wetting of substrates on which the composition is deposited.

A method of making cured films is accomplished by first preparing the composition by mixing the silicone resin, the organic mercaptan, the acrylate monomer, the photoinitiator and the free radical inhibitor to form a compatible, homogeneous blend, applying the composition to a substrate such as an electronics device and then irradiating the composition with ultraviolet radiation in an amount sufficient to cure the composition.

The compositions of this invention contain an effective amount of a free radical inhibitor to delay gelation during storage. These free radical inhibitors include p-methoxyphenol (also know as MEHQ), catechol, 4-t-butylcatechol, phenothiazine, 2,6-di-t-butyl-p-methyl-phenol and N-phenyl-2-naphthylamine. The amounts of the free radical inhibitors are from zero to one weight percent based on the weight of the composition, more preferably from 0.01 to 0.25 weight percent. The most preferred free radical inhibitors are p-methoxyphenol, phenothiazine and mixtures thereof. The presence of hydroquinone as a free radical inhibitor appears to be undesirable from the standpoint of preparing high modulus and tensile strength cured products.

The compositions of the present invention cure very well, adhere well to electronic boards, have a mild odor and are clear. The presence of the acrylate compound in these compositions is vital to protect copper from corroding. The compositions of the present invention exhibit improved adhesion by preventing salt water from creeping under the coating and corroding the metal. However, acrylates without the mercaptan compound exhibit insufficient cure and to obtain the excellent properties the silicone resin, mercaptan and acrylate are required. The thermal stability of the cured films made from the compositions of this invention can be expected to improve further by substituting hexenyl group for the vinyl group in the silicone resins. The compositions of this invention cure very rapidly compared to other ultraviolet radiation cured conformal coating compositions. They also can be cured in very deep sections when peroxide is added to them. These conformal coatings can be used as mar resistant conformal and protective coatings for printed circuit boards, gaskets for automobile engines, coatings for deep cross section pottants, optical fiber coatings

where the refractive index of these coatings is greater than 1.49.

The preferred composition consist essentially of silicone resin in an amount of greater than 35 weight percent, from 5 to 30 weight percent mercaptan compound, from 1 to 25 weight percent acrylate compound, from 1 to 4 weight percent photoinitiator, less than 0.05 weight percent free radical inhibitor and when present organic peroxide in amounts of from 1 to 5 weight percent. The weight percentages are based on the total weight of the composition.

It is also expected that the mercaptopropylsiloxane and mercaptobutylsiloxane containing polymers described in Lee et al may be useful as substitutes for the mercaptans of the present invention, especially those in which phenyl-containing siloxane units are also in the polymer. Additional modifications which may be useful include acrylate functional oligomers, other vinyl functional organic monomers, such as divinyl benzene and thiol functional silicone resins.

The following examples are presented for illustrative purposes and should not be construed as limiting the invention which is properly delineated in the claims. "Part or parts" are parts by weight and the viscosities are values measured at 25 ° C. Me = methyl, Ph = phenyl and Vi = vinyl.

Example 1

An ultraviolet radiation curable siloxane composition was prepared by mixing 100 parts of a silicone resin having the average siloxane unit formula

$$(MeSiO_{3/2})_{7.5}(PhSiO_{3/2})_{37.6}(Me_2SiO)_{30.1}(MeViSiO)_{20.0}\text{-}(Me_3SiO_{1/2})_{4.8}(OH)_h$$

which has a vinyl content of 5.2 weight percent, a value for h to provide an OH content of 1.49 weight percent, a non-volatile content of 97.4 weight percent and a viscosity of 14.5 Pa•s, 26.92 parts of an organic mercaptofunctional compound having the formula

$$CH_3CH_2C(CH_2O\overset{\overset{O}{\|}}{C}CH_2CH_2SH)_3$$

{trimethylolpropane tri(3-mercaptopropionate)} [TMPTMP], 15.38 parts of tripropylene glycol diacrylate [TRPGDA], 7.69 parts of isobornyl acrylate [IBA], 3.08 parts of photoinitiator of the formula

$$HO(CH_3)_2C\text{-}\overset{\overset{O}{\|}}{C}\text{-}C_6H_5$$

and 0.03 part of phenothiazine (Composition A).

For comparison an ultraviolet radiation curable siloxane composition was prepared by mixing 100 parts of the silicone resin as described above in this example, 26.62 parts of TMPTMP, 2.99 parts of the photoinitiator as described above and 0.05 part of phenothiazine (Comparative Composition A).

The Composition A and the Comparative Composition A were each coated on four, 1 inch by 3 inch, copper coupons. The coating (8 mils wet thickness) was cured by irradiating with ultraviolet radiation a medium pressure mercury vapor arc lamp (200 watts per inch) housed in UVEXS LCU 750 unit, manufactured by UVEXS, Inc of Mountain View, California. Each coated coupon was given four passes through the unit at six feet per minute to cure the composition.

The coupons with cured coating were exposed to 100 hours of salt fog according to ASTM-B-117-73. For a coating to pass this test, there must be no corrosion of the copper nor any softening, blistering, cracking or delamination of the coating. The four boards coated with Composition A passed this test with one board exhibiting a slight corrosion at the bottom of the coupon. The four boards coated with Comparative Composition A failed by exhibiting corrosion of the copper, cracking and delamination. This shows that the presence of the acrylate is vital to preventing corrosion of the copper coupons.

A composition which exhibited shadow cure was prepared by the addition of 3 parts of 1,1-bis-(t-butylperoxy) cyclohexane to Composition A. This composition cured to a depth of 3 inches when exposed

to ultraviolet radiation as described above. Heating the composition caused the composition to cure, but the surface was tacky due to oxygen inhibition. The composition cured by ultraviolet radiation had a tack free surface.

Example 2

Comparative compositions were prepared by mixing the ingredients shown in Table 1. These compositions were tested by coating coupons, curing and testing in the same manner as described in Example 1. The results were as shown in Table 2.

TABLE 1

| INGREDIENT | COMPOSITION, Weight % | | | | |
|---|---|---|---|---|---|
| | A | B* | C* | D* | E* |
| Silicone resin | 65.6 | 54.4 | 22.2 | 0.0 | 77.1 |
| TMPTMP | 17.5 | 43.6 | 50.8 | 43.6 | 20.6 |
| TRPGDA | 10.0 | 0.0 | 16.6 | 36.2 | 0.0 |
| IBA | 5.0 | 0.0 | 8.35 | 18.2 | 0.0 |
| Photoinitiator | 2.0 | 2.0 | 2.0 | 2.0 | 2.3 |
| Phenothiazine | 0.04 | 0.04 | 0.04 | 0.04 | 0.04 |

*Comparative Compositions

These compositions had the following sulfur to vinyl ratios.

Composition A had a sulfur:vinyl in silicone resin ratio of 1:1 and a total sulfur:vinyl ratio of 1:1.7(includes the C=C in the acrylate compound).

Comparative Composition B had a sulfur to vinyl ratio of 1:1.7 (no acrylate compound).

Comparative Composition C had a sulfur: total vinyl of 1:0.5 (0.1 mol vinyl from silicone resin, 0.3 mol vinyl from TRPGDA and 0.1 mol vinyl from IBA).

Comparative Composition D had a sulfur: vinyl in acrylate of 1:1 (no silicone resin).

Comparative Composition E had a sulfur: vinyl in silicone resin of 1:1 (no acrylate compound).

TABLE 2

| COMPOSITION | CORROSION | | | COATING APPEARANCE | | | |
|---|---|---|---|---|---|---|---|
| | NONE | MILD | SEVERE | BLISTERED | CRACKED | DELAMINATED | SOFTENED |
| A | X | -- | -- | -- | -- | -- | -- |
| B | -- | -- | X | X | X | X | X |
| C | -- | X | -- | -- | -- | -- | -- |
| D | -- | X | -- | -- | -- | -- | -- |
| E | -- | X | -- | -- | X | X | -- |

This data emphasized the need for both acrylate and silicone resin in the conformal coating compositions. Comparing Composition A with Comparative Composition D, showed that the thiol group preferred to cure with the vinyl from the silicone resin rather than with the vinyl from the acrylate. Comparative Composition D coating was very tacky before and after the salt fog testing and felt like it had not thoroughly cured. Comparative Composition C felt very similar to Comparative Composition D which suggested that the sulfur:vinyl in the silicone resin should be at least 1:1, because the acrylates do not cure well with the thiol (in this case the TMPTMP). When no acrylates were added to the formulation and the excess vinyl were present as in Comparative Composition B, the performance was the worst. It was believed that the acrylates help the adhesion which keeps the salt water from getting underneath the coating, thus causing the copper to corrode. Comparative Composition E supported this belief, where the sulfur to vinyl in the silicone resin

is kept constant but acrylates were removed from the composition, the coating delaminated and cracked.

Example 3

An ultraviolet radiation curable composition was prepared by mixing 65.6 parts of the silicone resin as described in Example 1, 17.5 parts of TMPTMP, 15 parts of a proprietary monofunctional aliphatic acrylate identified as C-9013 which was manufactured by ARCO Chemical Company of Pennsylvania, 2 parts of the photoinitiator as described in Example 1 and 0.02 part of phenothiazine (Composition F).

Another ultraviolet radiation curable composition was prepared by mixing the same ingredients as Composition F, except a trifunctional triacrylate ester identified as C-9012 which was manufactured by ARCO Chemical Company replaced the C-9013 (Composition G).

Both compositions were coated on copper coupons and cured as described in Example 1. These coupons were tested for corrosion resistance by exposure to 100 hours in the salt fog chamber as described in Example 1. Cured coatings of both compositions passed the salt fog test and exhibited enhance corrosion resistance.

Example 4

An ultraviolet radiation curable composition was prepared as described in Example 1 Composition A except that a silicone resin containing 75 mole percent monophenylsilsesquioxane units and 25 mole percent dimethylvinylsiloxane units replaced the silicone resin of Composition A (this composition is identified as Composition H).

Another ultraviolet radiation curable composition was prepared as described in Example 1 Composition A except that a silicone resin containing 27 mole percent monophenylsilsesquioxane units, 18 mole percent monomethylsilsesquioxane units, 18 mole percent dimethylsiloxane units, 12 mole percent diphenylsiloxane units and 25 mole percent methylvinylsiloxane units replaced the silicone resin of Composition A (this composition is identified as Composition I).

Both Composition H and Composition I cured well. Composition H cured fasted and deeper than Composition I and were similar to Composition A.

## Claims

**1.** A composition consisting essentially of a silicone resin having a general average unit formula

$$R_aSiO_{(4-a)/2}$$

in which each R in each unit is independently a monovalent organic radical where at least 10 mole percent of the total R are phenyl radicals and at least two R per molecule are aliphatic unsaturated radicals which react with mercapto functionality and a has an average value of from 1.2 to 1.8;

an organic mercaptan composed of carbon, hydrogen, sulfur, and oxygen in which there is at least two mercapto groups per molecule;

an acrylate monomer having at least one acrylate group per molecule in an amount of at least one weight percent based on the total weight of the composition;

an effective amount of photoinitiator to cause the composition to cure upon exposure to ultraviolet radiation; and

an effective amount of a free radical inhibitor to delay gelation during storage,

the composition has more than two aliphatic unsaturated radicals per molecule in the silicone resin when the organic mercaptan has two mercapto groups per molecule or more than two mercapto groups per molecule in the organic mercaptan when the silicone resin has an average of two aliphatic unsaturated radicals per molecule or both more than two aliphatic unsaturated radicals per molecule in the silicone resin and more than two mercapto groups per molecule in the organic mercaptan and amount of silicone resin and organic mercaptan being such that there is from 0.5 to 1.5 aliphatic unsaturated radicals in the silicone resin for each mercapto group in the organic mercaptan.

**2.** The composition according to claim 1 in which the silicone resin consists essentially of at least two siloxane units selected from the group consisting of monophenylsilsesquioxane, monomethylsilsesquioxane, dimethylsiloxane, diphenylsiloxane, methylvinylsiloxane, dimethylvinylsiloxy and trimethylsiloxy.

3. The composition according to claim 2 in which the silicone resins is made up of 20 to 40 mol percent monophenylsilsesquioxane units, 10 to 20 mol percent monomethylsilsesquioxane units, 20 to 35 mol percent dimethylsiloxane units and 10 to 30 mol percent methylvinylsiloxane units.

## Patentansprüche

1. Stoffmischung, im wesentlichen bestehend aus
einem Siliconharz mit einer durchschnittlichen allgemeinen Formel für die Einheit

$R_aSiO_{(4-a)/2}$,

in der jeder Substituent R in jeder Einheit unabhängig einen einwertigen organischen Rest bezeichnet, wobei mindestens 10 Molprozent der gesamten Substituenten R Phenylreste sind und mindestens zwei Substituenten R pro Molekül aliphatische ungesättigte Reste sind, die mit Mercapto-Funktionalität reagieren, und in der a einen durchschnittlichen Wert von 1,2 bis 1,8 besitzt;
einem organischen Merkaptan, das aus Kohlenstoff, Wasserstoff, Schwefel und Sauerstoff zusammengesetzt ist und mindestens zwei Mercaptogruppen pro Molekül enthält;
einem Acrylatmonomeren mit mindestens einer Acrylatgruppe pro Molekül in einer Menge von mindestens 1 Gewichtsprozent, bezogen auf das Gesamtgewicht der Stoffmischung;
einer wirksamen Menge eines Photoinitiators, der die Stoffmischung bei Einwirkung von ultravioletter Strahlung vernetzen läßt; und
einer wirksamen Menge eines Inhibitors für freie Radikale zur Verzögerung der Gelierung bei Lagerung;
wobei die Stoffmischung mehr als zwei aliphatische ungesättigte Reste pro Molekül in dem Siliconharz aufweist, wenn das organische Merkaptan zwei Mercaptogruppen pro Molekül enthält, oder mehr als Zwei Mercaptogruppen pro Molekül in dem organischen Merkaptan aufweist, wenn das Siliconharz durchschnittlich zwei aliphatische ungesättigte Reste pro Molekül enthält, oder sowohl mehr als zwei aliphatische ungesättigte Reste pro Molekül in dem Siliconharz aufweist, als auch mehr als als zwei Mercaptogruppen pro Molekül in dem organischen Merkaptan enthält, und wobei die Mengen des Siliconharzes und des organischen Merkaptans so gewählt sind, daß 0,5 bis 1,5 aliphatische ungesättigte Reste in dem Siliconharz auf jede Mercaptogruppe in dem organischen Merkaptan entfallen.

2. Stoffmischung nach Anspruch 1, wobei das Siliconharz im wesentlichen aus mindestens zwei Siloxan-Einheiten besteht, ausgewählt aus Monophenylsilsesquioxan, Monomethylsilsesquioxan, Dimethylsiloxan, Diphenylsiloxan, Methylvinylsiloxan, Dimethylvinylsiloxy und Trimethylsiloxy.

3. Stoffmischung nach Anspruch 2, wobei das Siliconharz aus 20 bis 40 Molprozent Monophenylsilsesquioxan-Einheiten, 10 bis 20 Molprozent Monomethylsilsesquioxan-Einheiten, 20 bis 35 Molprozent Dimethylsiloxan-Einheiten und 10 bis 30 Molprozent Methylvinylsiloxan-Einheiten besteht.

## Revendications

1. Composition essentiellement constituée d'une résine de silicone ayant une formule unitaire moyenne générale

$R_aSiO_{(4-a)/2}$

dans laquelle chaque R dans chaque unité est indépendamment un radical organique monovalent, où au moins 10 % en moles des R totaux sont des radicaux phényles et au moins deux R par molécule sont des radicaux aliphatiques insaturés qui réagissent avec une fonctionnalité mercapto, et a a une valeur moyenne de 1,2 à 1,8 ;
d'un mercaptan organique composé de carbone, d'hydrogène, de soufre, et d'oxygène, dans lequel il y a au moins deux groupes mercaptos par molécule ;
d'un monomère acrylate ayant au moins un groupe acrylate par molécule, en une quantité d'au moins 1 % en poids sur la base du poids total de la composition ;
d'une quantité efficace d'un photo-initiateur pour provoquer le durcissement de la composition par exposition à une radiation ultraviolette ; et
d'une quantité efficace d'un inhibiteur de radicaux libres pour retarder la gélification au stockage,
la composition a plus de deux radicaux aliphatiques insaturés par molécule dans la résine de

silicone lorsque le mercaptan organique a deux groupes mercaptos par molécule, ou plus de deux groupes mercaptos par molécule dans le mercaptan organique lorsque la résine de silicone a une moyenne de deux radicaux aliphatiques insaturés par molécule, ou à la fois plus de deux radicaux aliphatiques insaturés par molécule dans la résine de silicone et plus de deux groupes mercaptos par molécule dans le mercaptan organique, et les quantités de résine de silicone et de mercaptan organique étant telles qu'il y ait de 0,5 à 1,5 radical aliphatique insaturé dans la résine de silicone pour chaque groupe mercapto dans le mercaptan organique.

**2.** Composition selon la revendication 1, dans laquelle la résine de silicone est essentiellement constituée d'au moins deux unités siloxanes choisies dans le groupe constitué des unités monophénylsilsesquioxane, monométhylsilsesquioxane, diméthylsiloxane, diphénylsiloxane, méthylvinylsiloxane, diméthylvinylsiloxy et triméthylsiloxy.

**3.** Composition selon la revendication 2, dans laquelle la résine de silicone est constituée de 20 à 40 % en moles d'unités monophénylsilsesquioxanes, de 10 à 20 % en moles d'unités monométhylsilsesquioxanes, de 20 à 35 % en moles d'unités diméthylsiloxanes et de 10 à 30 % en moles d'unités méthylvinylsiloxanes.